(19) Europäisches Patentamt
European Patent Office
Office européen des brevets

(11) **EP 3 992 013 A1**

(12) **EUROPEAN PATENT APPLICATION**

(43) Date of publication:
**04.05.2022 Bulletin 2022/18**

(21) Application number: **21197567.7**

(22) Date of filing: **17.09.2021**

(51) International Patent Classification (IPC):
**B60L 50/16** (2019.01)    **B60L 50/61** (2019.01)
**B60L 58/12** (2019.01)    **B60L 58/16** (2019.01)
**B60L 3/00** (2019.01)    **G01R 31/392** (2019.01)
**H02J 7/00** (2006.01)    **B60K 6/445** (2007.10)
**B60W 20/00** (2016.01)

(52) Cooperative Patent Classification (CPC):
**B60L 58/16; B60K 6/445; B60L 3/0046;**
**B60L 50/16; B60L 50/61; B60L 58/12;**
**B60W 20/00; G01R 31/392; H02J 7/005;**
B60L 2240/12; B60L 2240/441; B60L 2240/443

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **22.10.2020 JP 2020177583**

(71) Applicant: **TOYOTA JIDOSHA KABUSHIKI**
**KAISHA**
**Toyota-shi, Aichi-ken, 471-8571 (JP)**

(72) Inventor: **YAMASHITA, Yoshiya**
**Toyota-shi, Aichi-ken, 471-8571 (JP)**

(74) Representative: **Cabinet Beau de Loménie**
**158, rue de l'Université**
**75340 Paris Cedex 07 (FR)**

(54) **DEGRADATION DETERMINATION DEVICE FOR SECONDARY BATTERY**

(57)    A degradation determination device for a secondary battery (50) is used for a hybrid vehicle (20), is configured to determine degradation of the secondary battery (50), and includes a processor. The processor is configured to determine whether predetermined charge control is executed based on a vehicle speed (88), an accelerator operation amount (84), and a fuel injection amount or a rotational speed. The processor determines that degradation of the secondary battery (50) has progressed when a charge frequency is high compared to when the charge frequency is low. The charge frequency is the ratio of the time for which the predetermined charge control is executed to a required time for a predetermined period.

FIG. 1

EP 3 992 013 A1

**Description**

1. Field of the Invention

The present invention relates to a degradation determination device for a secondary battery, and particularly relates to a degradation determination device for a secondary battery for use in a hybrid vehicle including an engine, a motor, and a secondary battery.

2. Description of Related Art

There is proposed a degradation determination device for a secondary battery of this type, including a communication terminal device and a server (see Japanese Unexamined Patent Application Publication No. 2008-76295 (JP 2008-76295 A), for example). The communication terminal device includes a constant-current load circuit that keeps a battery current of the secondary battery (battery pack) at a constant current. The communication terminal device detects an internal resistance value by measuring a battery voltage with a battery current of the secondary battery kept at a constant value using the constant-current load circuit, and transmits the detected internal resistance value to the server. The server determines degradation (life) of the secondary battery based on the received internal resistance value. Consequently, degradation of the secondary battery which is operating is determined remotely from the server.

SUMMARY OF THE INVENTION

However, the degradation determination device for a secondary battery discussed above requires the constant-current load circuit in order to detect an internal resistance value of the secondary battery. Therefore, when the degradation determination device for a secondary battery discussed above is used for a hybrid vehicle including an engine and a motor, it is necessary to newly add a constant-current load circuit, which disadvantageously increases the number of parts. In the hybrid vehicle, various types of control are executed on the engine and the motor using a user operation amount, which is the amount of an operation on an accelerator pedal etc. by a user, and various types of control amounts. Therefore, it is desired to determine degradation of the secondary battery based on the user operation amount and the control amounts which are used to control the hybrid vehicle, without adding a device exclusively for detecting an internal resistance value such as the constant-current load circuit.

The present invention provides a degradation determination device for a secondary battery, the degradation determination device being capable of determining degradation of the secondary battery based on control executed in a hybrid vehicle.

A degradation determination device for a secondary battery according to an aspect of the present invention is used for a hybrid vehicle, and configured to determine degradation of the secondary battery. The hybrid vehicle includes an engine configured to output power for travel, a motor configured to output power for travel, the secondary battery that is configured to exchange electric power with the motor, and a control device configured to execute predetermined charge control for controlling the engine and the motor using at least a vehicle speed, an accelerator operation amount, and a fuel injection amount of the engine or a rotational speed of the engine such that the secondary battery is charged using power from the engine when a predetermined condition is established. The degradation determination device includes a processor. The processor is configured to determine whether the predetermined charge control is executed based on the vehicle speed, the accelerator operation amount, and the fuel injection amount or the rotational speed. The processor is configured to determine that degradation of the secondary battery has progressed when a charge frequency is high compared to when the charge frequency is low, the charge frequency being a ratio of a time for which the predetermined charge control is executed to a required time for a predetermined period.

The degradation determination device for a secondary battery according to the aspect of the present invention is used for a hybrid vehicle that executes the predetermined charge control for controlling the engine and the motor such that the secondary battery is charged using power from the engine using at least the vehicle speed, the accelerator operation amount, and either the fuel injection amount of the engine or the rotational speed of the engine when the predetermined condition is established. In the degradation determination device for a secondary battery according to the aspect of the present invention, it is determined whether the predetermined charge control is executed based on the vehicle speed, the accelerator operation amount, and either the fuel injection amount or the rotational speed of the engine. It is determined that degradation of the secondary battery has progressed when the charge frequency is high compared to when the charge frequency is low, the charge frequency being the ratio of the time for which the predetermined charge control is executed to the required time for the predetermined period. When degradation of the secondary battery has progressed, the power accumulation proportion of the secondary battery tends to be lowered, and thus it is considered that the predetermined charge control is executed more frequently. Thus, it can be determined that degradation of the secondary battery has progressed when the charge frequency is high compared to when the charge frequency is low. It is possible to determine degradation of the secondary battery based on control executed in the hybrid vehicle, by determining degradation of the secondary battery based on the charge frequency.

In the degradation determination device for a secondary battery according to the aspect of the present invention, the predetermined period may be a period since a system of the hybrid vehicle is started until the system is stopped. With the degradation determination device for a secondary battery according to the aspect of the present invention, the period for which the time for which the predetermined charge control is executed is stored can be shortened compared to a configuration in which the predetermined period is determined as a period since the system of the hybrid vehicle is first started after manufacture until present. Consequently, degradation of the secondary battery can be determined even if no mass storage device is provided.

In the degradation determination device for a secondary battery according to the aspect of the present invention, the processor may be configured to determine that the degradation progresses faster when a value obtained by dividing an integrated value of time-series data on a third parameter in the predetermined period by a travel distance in the predetermined period is larger than when the value is smaller. With the degradation determination device for a secondary battery according to the aspect of the present invention, the first parameter which is based on the accelerator operation amount reflects required power required for travel. The second parameter which is based on the fuel injection amount of the engine reflects power output from the engine. In the hybrid vehicle, power as the difference between the required power and the power from the engine corresponds to electric power input to and output from the secondary battery. Thus, the third parameter, which is the difference between the first parameter and the second parameter, reflects electric power input to and output from the secondary battery. Degradation of the secondary battery is correlated with electric power input to and output from the secondary battery. Thus, it is possible to determine that degradation of the secondary battery progresses faster when a value obtained by dividing the integrated value of the time-series data on the third parameter in the predetermined period by the travel distance in the predetermined period is larger than when the value is smaller. Consequently, degradation of the secondary battery can be determined more precisely.

In this case, the first parameter may be the accelerator operation amount, and the second parameter may be the proportion of output of the engine, which is based on the fuel injection amount, to maximum output as the maximum value of power that can be output from the engine.

In the degradation determination device for a secondary battery according to the aspect of the present invention, the processor may be configured to determined that the degradation progresses faster when a value obtained by calculating a sum of an integrated value of time-series data on a third parameter in the predetermined period and an integrated value of time-series data on a fourth parameter in the predetermined period and dividing the calculated sum by a travel distance in the predetermined period is larger than when the value is smaller, the third parameter being a difference between a first parameter based on the accelerator operation amount and a second parameter based on the fuel injection amount, and the fourth parameter being based on a deceleration amount of the hybrid vehicle. With the degradation determination device for a secondary battery according to the aspect of the present invention, the first parameter which is based on the accelerator operation amount reflects required power required for travel. The second parameter which is based on the fuel injection amount of the engine reflects power output from the engine. In the hybrid vehicle, power as the difference between the required power and the power from the engine corresponds to electric power input to and output from the secondary battery. Thus, the third parameter, which is the difference between the first parameter and the second parameter, reflects electric power input to and output from the secondary battery. The deceleration amount reflects braking torque that acts on the hybrid vehicle, that is, electric power regenerated by the motor to be stored in the secondary battery during deceleration. Thus, the fourth parameter reflects electric power input to the secondary battery during deceleration. Degradation of the secondary battery is correlated with electric power input to and output from the secondary battery. Therefore, it is possible to determine that degradation of the secondary battery progresses faster when a value obtained by calculating the sum of the integrated value of the time-series data on the third parameter in the predetermined period and the integrated value of the time-series data on the fourth parameter in the predetermined period and dividing the calculated sum by the travel distance in the predetermined period is larger than when the value is smaller. Consequently, degradation of the secondary battery can be determined more precisely.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

FIG. 1 is a diagram illustrating a schematic configuration of a vehicle diagnosis system 10 that includes a degradation determination device for a secondary battery according to an embodiment of the present invention;
FIG. 2 is a diagram illustrating a schematic configuration of a hybrid automobile 20;
FIG. 3 is a diagram illustrating a schematic configuration of an engine 22;
FIG. 4 is a flowchart illustrating an example of a remaining life determination routine executed by a computer 92 of a management center 90; and
FIG. 5 illustrates an example of a remaining life setting map.

## DETAILED DESCRIPTION OF EMBODIMENTS

Next, a mode for carrying out the present invention will be described using an embodiment.

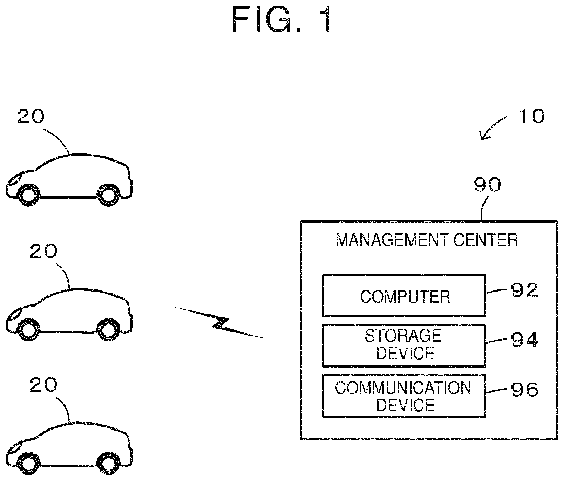

FIG. 1 is a diagram illustrating a schematic configuration of a vehicle diagnosis system 10 that includes a degradation determination device for a secondary battery according to an embodiment of the present invention. As illustrated in the drawing, the vehicle diagnosis system 10 includes a plurality of hybrid automobiles 20 and a management center 90.

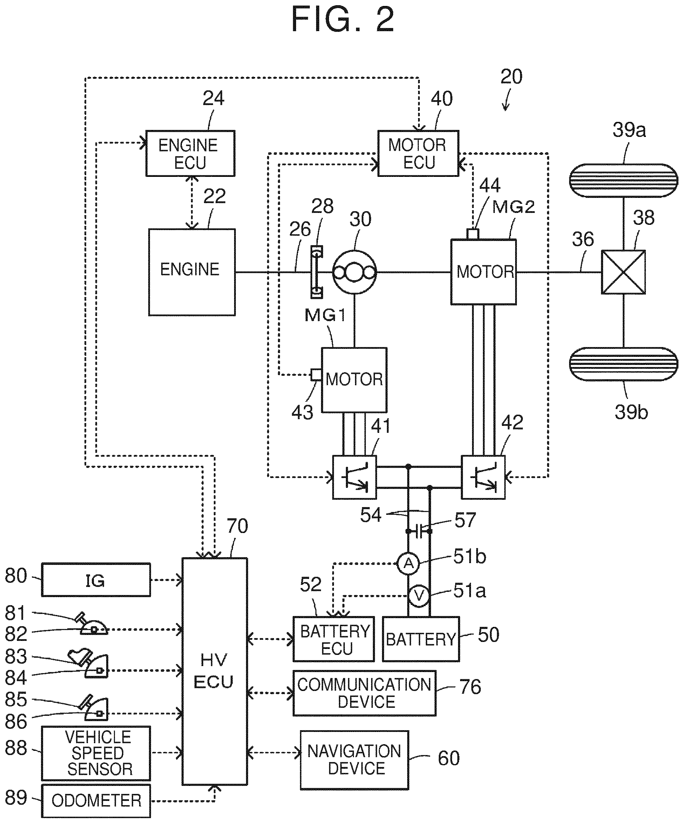

FIG. 2 is a diagram illustrating a schematic configuration of the hybrid automobile 20. As illustrated in the drawing, the hybrid automobile 20 includes an engine 22, a planetary gear 30, motors MG1, MG2, inverters 41, 42, a battery 50, a navigation device 60, and a hybrid electronic control unit (hereinafter referred to as an "HV ECU") 70.

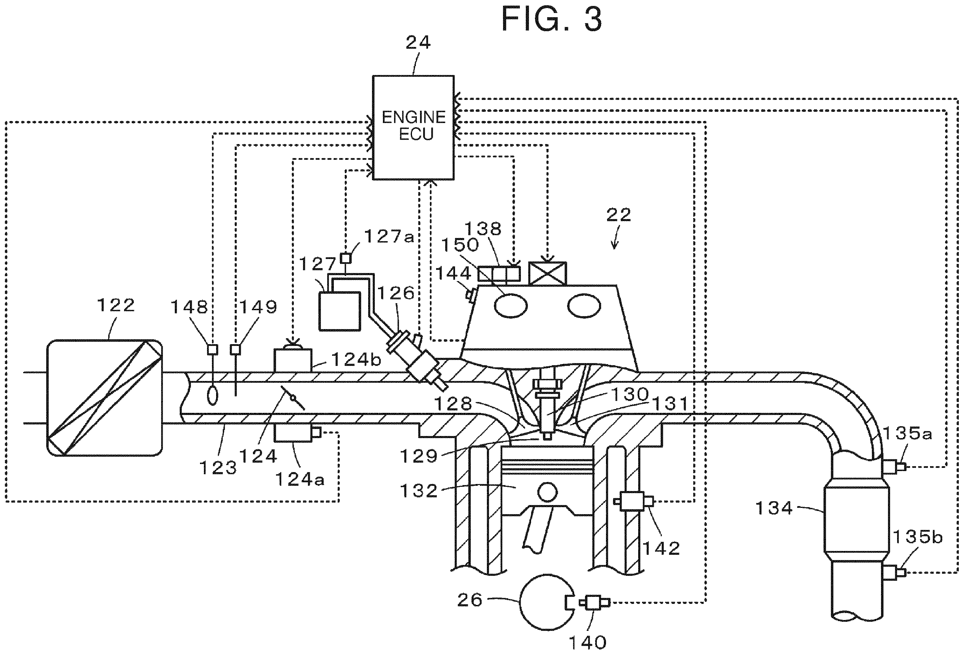

The engine 22 is constituted as an internal combustion engine that outputs power using gasoline, light oil, etc. as fuel, and connected to a carrier of the planetary gear 30 via a damper 28. FIG. 3 is a diagram illustrating a schematic configuration of the engine 22. As illustrated in the drawing, the engine 22 takes in air cleaned by an air cleaner 122 via a throttle valve 124 disposed in an intake pipe (intake port) 123 and injects fuel from a fuel injection valve 126 to mix the air and the fuel. The air-fuel mixture is taken into a combustion chamber (inside a cylinder) 129 via an intake valve 128. The air-fuel mixture that has been taken in is ignited and combusted by an electric spark generated by a spark plug 130. Reciprocal motion of a piston 132 which is pressed down by the energy of the combustion is converted into rotational motion of a crankshaft 26. Exhaust from the combustion chamber 129 is discharged to the outside via an exhaust gas control device 134 that has an exhaust gas control catalyst (three-way catalyst) that removes harmful components such as carbon monoxide (CO), hydrocarbons (HC), and nitrogen oxides (NOx). Operation of the engine 22 is controlled by an engine electronic control unit (hereinafter referred to as an "engine ECU") 24.

The engine 22 includes a variable valve timing mechanism 150. The variable valve timing mechanism 150 changes an open/close timing VTin of the intake valve 128 with the operation angle maintained, by changing the phase of an intake cam with respect to an intake camshaft.

The engine ECU 24 is constituted as a microprocessor including a central processing unit (CPU) as its main component, and includes a read only memory (ROM) that stores a processing program, a random access memory (RAM) that temporarily stores data, input and output ports, and a communication port, besides the CPU, although not illustrated.

Signals from various sensors required to control operation of the engine 22 are input to the engine ECU 24 via the input port. Examples of the signals from the various sensors include: a crank angle $\theta cr$ from a crank position sensor 140 that detects the rotational position of the crankshaft 26; a coolant temperature Tw from a coolant temperature sensor 142 that detects the temperature of coolant of the engine 22; a throttle opening degree TH from a throttle valve position sensor 124a that detects the position of the throttle valve 124; a cam position from a cam position sensor 144 that detects the rotational position of a camshaft that opens and closes the intake valve 128 and an exhaust valve 131 that allow air to be taken into and discharged from the combustion chamber 129; an intake air amount Qa from an airflow meter 148 attached to the intake pipe (intake port) 123; an intake air temperature from a temperature sensor 149 also attached to the intake pipe (intake port) 123; an air-fuel ratio AF from an air-fuel ratio sensor 135a; an oxygen signal from an oxygen sensor 135b; and a fuel pressure Pf from a fuel pressure sensor 127a that detects the pressure of fuel in a fuel tank 127.

Various control signals for controlling operation of the engine 22 are output from the engine ECU 24 via the output port. Examples of the various control signals include: a drive control signal for a throttle motor 124b that adjusts the position of the throttle valve 124; a drive control signal for the fuel injection valve 126; a drive control signal for an ignition coil 138 integrated with an ignitor; and a control signal for the variable valve timing mechanism 150.

The engine ECU 24 is connected to the HV ECU 70 via the communication port, and controls operation of the engine 22 in accordance with a control signal from the HV ECU 70. In addition, the engine ECU 24 outputs data related to the operation state of the engine 22 to the HV ECU 70 as necessary. The engine ECU 24 computes the rotational speed of the crankshaft 26, that is, a rotational speed Ne of the engine 22, based on the crank angle $\theta cr$. The engine ECU 24 computes a load factor KL (the ratio of the volume of air actually taken in in one cycle to the piston displacement per one cycle of the engine 22) based on the computed rotational speed Ne of the engine 22 and the intake air amount Qa from the airflow meter 148.

The planetary gear 30 is constituted as a single-pinion planetary gear mechanism. A rotor of the motor MG1 is connected to a sun gear of the planetary gear 30. A drive shaft 36, which is coupled to drive wheels 39a, 39b via a differential gear 38, is connected to a ring gear of the planetary gear 30. The crankshaft 26 of the engine 22 is connected to a carrier of the planetary gear 30 via the damper 28.

The motor MG1 is constituted as a synchronous generator/motor, for example. As discussed above, the rotor of the motor MG1 is connected to the sun gear of the planetary gear 30. The motor MG2 is constituted as a synchronous generator/motor, for example. A rotor of the motor MG2 is connected to the drive shaft 36. The inverters 41, 42 are used to drive the motors MG1, MG2, respectively, and connected to the battery 50 via a power line 54. A smoothing capacitor 57 is attached to the power line 54. A motor electronic control unit (hereinafter referred to as a "motor ECU") 40 controls switching of a plurality of switching elements (not illustrated) of the inverters 41, 42 such that the motors MG1, MG2 are rotationally driven, respectively.

The motor ECU 40 is constituted as a microprocessor including a CPU as its main component, and includes a ROM that stores a processing program, a RAM that temporarily stores data, input and output ports, and a communication port, besides the CPU, although not illustrated. The motor ECU 40 receives input of signals from various sensors required to control drive of the motors MG1, MG2, such as rotational positions $\theta m1$, $\theta m2$ from rotational position detection sensors 43, 44 that detect the rotational positions of the rotors of the motors MG1, MG2, respectively, for example, via the input port. The motor ECU 40 outputs switching control signals for the plurality of switching elements of the inverters 41, 42 etc. via the output port. The motor ECU 40 is connected to the HV ECU 70 via the communication port.

The battery 50 is constituted as a nickel-metal-hydride secondary battery, for example, and connected to the power line 54. The battery 50 is managed by a battery electronic control unit (hereinafter referred to as a "battery ECU") 52.

The battery ECU 52 is constituted as a microprocessor including a CPU as its main component, and includes a ROM that stores a processing program, a RAM that temporarily stores data, input and output ports, and a communication port, besides the CPU, although not illustrated. Signals from various sensors required to manage the battery 50 are input to the battery ECU 52 via the input port. Examples of the signals input to the battery ECU 52 include a voltage Vb of the battery 50 from a voltage sensor 51a attached between the terminals of the battery 50, and a current Ib of the battery 50 from a current sensor 51b attached to an output terminal of the battery 50. The battery ECU 52 is connected to the HV ECU 70 via the communication port. In addition, the battery ECU 52 computes a power accumulation proportion SOC, which is the proportion of the capacity of electric power that can be discharged from the battery 50 at that time to the total capacity, based on an integrated value of a charge/discharge current Ib detected by a current sensor, in order to manage the battery 50.

The navigation device 60 includes a body with a built-in control unit that has a storage medium such as a hard disk that stores map information etc., input and output ports, and a communication port, a global positioning system (GPS) antenna that receives information related to the present location of the vehicle itself, and a touch-panel display that displays information related to the present location of the vehicle itself and various pieces of information such as an expected travel path to a destination and that enables the user to input various instructions, although not illustrated. The map information stores service information (e.g. sightseeing information, parking lots, etc.), road information on travel sections (e.g. between traffic lights, between intersections, etc.), etc. as a database. The road information includes distance information, road width information, lane number information, area information (urban or suburban), type information (general road or highway), gradient information, legal speed, number of traffic lights, etc. The information related to the present location of the vehicle itself includes present position information Gp, which includes the latitude and longitude of the present location, and a GPS time stamp Tgps, which indicates the present time. The navigation device 60 is connected to the HV ECU 70 via the communication port.

The HV ECU 70 is constituted as a microprocessor including a CPU as its main component, and includes a ROM that stores a processing program etc., a RAM that temporarily stores data, a non-volatile memory that stores data, input and output ports, and a communication port, besides the CPU, although not illustrated.

Signals from various sensors are input to the HV ECU 70 via the input port. Examples of the signals input to the HV ECU 70 include an ignition signal Sig from an ignition switch 80 and a shift position SP from a shift position sensor 82 that detects the operation position of a shift lever 81. Other examples include an accelerator operation amount Acc from an accelerator pedal position sensor 84 that detects the amount of depression of an accelerator pedal 83, a brake pedal position BP from a brake pedal position sensor 86 that detects the amount of depression of a brake pedal 85, a vehicle speed V from a vehicle speed sensor 88 that detects the vehicle speed, and a travel distance D from an odometer 89 that detects the travel distance accumulated from completion of manufacturing of the vehicle to the present time. The accelerator operation amount Acc is the proportion of the amount of depression of the accelerator pedal 83 to a maximum depression amount determined in advance as the maximum value of the amount of depression of the accelerator pedal 83. The accelerator operation amount Acc is 0% when the accelerator pedal 83 is not depressed. Further, signals such as the present position information Gp from the navigation device 60 are input to the HV ECU 70 via the input port.

The HV ECU 70 computes a travel distance Dtrip in a trip based on the travel distance D from the odometer 89. A trip is a period since the system of the vehicle is started by turning on the ignition switch 80 until the system of the vehicle is stopped by turning off the ignition switch 80.

As discussed above, the HV ECU 70 is connected to the engine ECU 24, the motor ECU 40, and the battery ECU 52 via the communication port.

A communication device 76 is constituted as a device that communicates with a communication device 96 of the management center 90. The communication device 76 is connected to the HV ECU 70 via the communication port, and transmits various data from the HV ECU 70 to the management center 90.

The thus configured hybrid automobile 20 travels in an electric travel mode (EV travel mode) in which the hybrid automobile 20 travels without driving the engine 22 and a hybrid travel mode (HV travel mode) in which the hybrid automobile 20 travels while driving the engine 22.

In the EV travel mode, the HV ECU 70 first sets required torque Td*, which is required for travel (required for the drive shaft 36), based on the accelerator operation amount Acc and the vehicle speed V. Subsequently, the HV ECU 70 sets a torque command Tm1* for the motor MG1 to a value of 0, sets a torque command Tm2* for the motor MG2 such that the required torque Td* is output to the drive shaft 36, and transmits the set torque commands Tm1*, Tm2* for the motors MG1, MG2, respectively, to the motor ECU 40. The motor ECU 40 performs switching control on the plurality of switching elements of the inverters 41, 42 such that the motors MG1, MG2 are driven in accordance with the torque commands Tm1*, Tm2*, respectively. The HV ECU 70 executes the process discussed above each predetermined time tref (e.g. several milliseconds etc.).

In the HV travel mode, the HV ECU 70 first sets the required torque Td*, as in the EV travel mode. Subsequently, the HV ECU 70 computes required power Pd*, which is required for travel, by multiplying the required torque Td* by a rotational speed Nd of the drive shaft 36, and computes required power Pe*, which is required for the engine 22, by subtracting charge/discharge required power Pb* for the battery 50 from the required power Pd*. The charge/discharge required power Pb* has a positive value when power is discharged from the battery 50. Examples of the rotational speed Nd of the drive shaft 36 include a rotational speed Nm2 of the motor MG2 and a rotational speed obtained by multiplying the vehicle speed V by a conversion coefficient. Then, the HV ECU 70 sets a target rotational speed Ne* and target torque Te* for the engine 22 and the torque commands Tm1*, Tm2* for the motors MG1, MG2, respectively, such that the required power Pe* is output from the engine 22 and the required torque Td* is output to the drive shaft 36, transmits the target rotational speed Ne* and the target torque Te* for the engine 22 to the engine ECU 24, and transmits the torque commands Tm1*, Tm2* for the motors MG1, MG2, respectively, to the motor ECU 40. The HV ECU 70 executes the process discussed above each predetermined time tref. The engine ECU 24 performs intake air amount control, fuel injection control, ignition control, etc. on the engine 22 such that the engine 22 is driven based on the target rotational speed Ne* and the target torque Te*. The control performed on the motors MG1, MG2 (inverters 41, 42) by the motor ECU 40 has been discussed above.

In the intake air amount control, the engine ECU 24 sets a target air amount Qa* based on the target torque Te* for the engine 22, sets a target throttle opening degree TH* such that the intake air amount Qa is brought to the target air amount Qa*, and controls the throttle motor 124b such that the throttle opening degree TH of the throttle valve 124 is brought to the target throttle opening degree TH*.

In the fuel injection control, the engine ECU 24 sets a target fuel injection amount Qf* based on the intake air amount Qa such that the air-fuel ratio AF is brought to a target air-fuel ratio AF* (e.g. the stoichiometric air-fuel ratio), computes a valve opening time tfopen of the fuel injection valve 126 from the fuel pressure Pf and the target fuel injection amount Qf*, and controls the fuel injection valve 126 so as to open for the valve opening time tfopen. Then, the engine ECU 24 computes a fuel injection amount Qf from the fuel pressure Pf and the valve opening time tfopen, and transmits the fuel injection amount Qf to the HV ECU 70.

In the ignition control, the engine ECU 24 sets a target ignition timing Tf* based on the rotational speed Ne and the target torque Te* for the engine 22, and controls the spark plug 130 such that ignition is performed at the target ignition timing Tf*.

In the hybrid automobile 20 according to the embodiment, when the accelerator operation amount Acc has a value of 0, the HV ECU 70 transmits a fuel cut command for the engine 22 to the engine ECU 24, sets the torque commands Tm1*, Tm2* for the motors MG1, MG2, respectively, such that the required torque Td* (basically braking torque) is output to the drive shaft 36 by fuel cut for the engine 22, motoring of the engine 22 by the motor MG1, and drive of the motor MG2, and transmits the torque commands Tm1*, Tm2* for the motors MG1, MG2, respectively, to the motor ECU 40. When the fuel cut command is received, the engine ECU 24 adjusts the position of the throttle valve 124 by controlling the throttle motor 124b such that the opening degree of the throttle valve 124 is brought to a predetermined opening degree THfc, and stops the fuel injection control (injection of fuel from the fuel injection valve 126), the ignition control, and open/close timing control for the engine 22. The predetermined opening degree THfc is an opening degree of full closure or several percent (e.g. 1%, 2%, 3%, etc.). When a return condition for starting the fuel injection such as the accelerator-on state is established, the engine ECU 24 resumes the intake air amount control, the fuel injection control, the ignition control, the open/close timing control, etc. on the engine 22. The control performed on the inverters 41, 42 by the motor ECU 40 has been discussed above.

In the hybrid automobile 20 according to the embodiment, when the power accumulation proportion SOC of the battery 50 is less than a predetermined proportion SOCmin, predetermined charge control in which the battery 50 is charged by driving the engine 22 (starting the engine 22 when drive of the engine 22 is stopped) is executed, even during EV travel or when the accelerator operation amount Acc has a value of 0. At this time, the HV ECU 70 controls the engine 22 and the motors MG1, MG2 in the same manner as in the HV travel mode discussed above.

The management center 90 includes a computer 92 that serves as a management server, a storage device 94, and the communication device 96. The computer 92 has a ROM that stores a processing program, a RAM that temporarily stores data, input and output ports, a communication port, etc., besides a CPU that serves as a processor. The storage device 94 is constituted as a hard disk, a solid state drive (SSD), etc., for example. The storage device 94 stores map information that is identical to the map information stored in the navigation device 60 of each hybrid automobile 20. The communication device 96 communicates with the communication device 76 of each hybrid automobile 20. The computer 92, the storage device 94, and the communication device 96 are connected to each other via a signal line.

Next, operation of the thus configured vehicle diagnosis system 10, in particular operation for determining the remaining life (degradation) of the battery 50, will be described. Operation of the hybrid automobile 20 will be described first, and operation of the management center 90 will be described next.

The communication device 76 of each hybrid automobile 20 transmits, to the management center 90, a vehicle identification number VIN, a detection time Time, the rotational speed Ne of the engine 22, the fuel injection amount Qf, the accelerator operation amount Acc, and the vehicle speed V each predetermined time tref since the ignition switch 80 is turned on until the ignition switch 80 is turned off. The vehicle identification number VIN is a number assigned to individual vehicles in order to identify the individual vehicles, and is a 17-letter code composed of alphabets and numerals, for example. The detection time Time is obtained by receiving the GPS time stamp Tgps received by the navigation device 60 through communication via the HV ECU 70. The rotational speed Ne of the engine 22 and the fuel injection amount Qf are obtained by receiving those values computed by the engine ECU 24 through communication via the HV ECU 70. The accelerator operation amount Acc is obtained by receiving the value detected by the accelerator pedal position sensor 84 through communication via the HV ECU 70. The vehicle speed V is obtained by receiving the value detected by the vehicle speed sensor 88 through communication via the HV ECU 70.

When the ignition switch 80 is turned off, the communication device 76 of each hybrid automobile 20 transmits the vehicle identification number VIN of the vehicle itself, the travel distance Dtrip in the trip, and a vehicle weight Mhv to the management center 90. The travel distance Dtrip is obtained by receiving the value computed based on the travel distance D from the odometer 89 through communication via the HV ECU 70. The vehicle weight Mhv is obtained by receiving the value stored in the ROM (not illustrated) of the HV ECU 70 as a value indicated in the specifications through communication.

Next, operation of the management center 90 will be described. A process of storing data from the hybrid automobile 20 in the storage device 94 of the management center 90 will be described first, and a process of determining the remaining life (degradation) of the battery 50 will be described next.

The communication device 96 of the management center 90 receives the vehicle identification number VIN, the detection time Time, the rotational speed Ne of the engine 22, the fuel injection amount Qf, the accelerator operation amount Acc, and the vehicle speed V, which are transmitted from each hybrid automobile 20 each predetermined time tref, and transmits such data to the computer 92 as a time-series data set. The communication device 96 receives the vehicle identification number VIN, the travel distance Dtrip, and the vehicle weight Mhv, which are transmitted from each hybrid automobile 20 when the ignition switch 80 is turned off, and transmits such data to the computer 92 as a non-time-series data set.

When the time-series data set is received, the computer 92 saves the received time-series data set in the storage device 94. When a time-series data set including the identical vehicle identification number VIN is received the next time, the computer 92 saves the time-series data set received next in a different storage area without overwriting time-series data sets that have been saved. Through such processing, time-series data sets are accumulated in the storage device 94 each predetermined time tref.

When the non-time-series data set is received, the computer 92 saves the received non-time-series data set in the storage device 94. The non-time-series data set includes the vehicle identification number VIN, the travel distance Dtrip, and the vehicle weight Mhv, which are received from the hybrid automobile 20 when the ignition switch 80 is turned off. Thus, the computer 92 determines that the system of the vehicle is stopped with the ignition switch 80 of the hybrid automobile 20 turned off at the timing when the non-time-series data set is received. Then, when a time-series data set including the same vehicle identification number VIN is input after that, it is determined that the system of the vehicle is started with the ignition switch 80 of the hybrid automobile 20 corresponding to the vehicle identification number VIN turned on, and the input time-series data set is saved in the storage device 94 after deleting all the time-series data sets corresponding to the vehicle identification number VIN, among the time-series data sets saved in the storage device 94. Through such processing, k (the value k is a natural number of 2 or more) time-series data sets for each trip of each hybrid automobile 20 are saved in the storage device 94 for a period since the ignition switch 80 of the hybrid automobile 20 is turned off until the ignition switch 80 is turned on the next time.

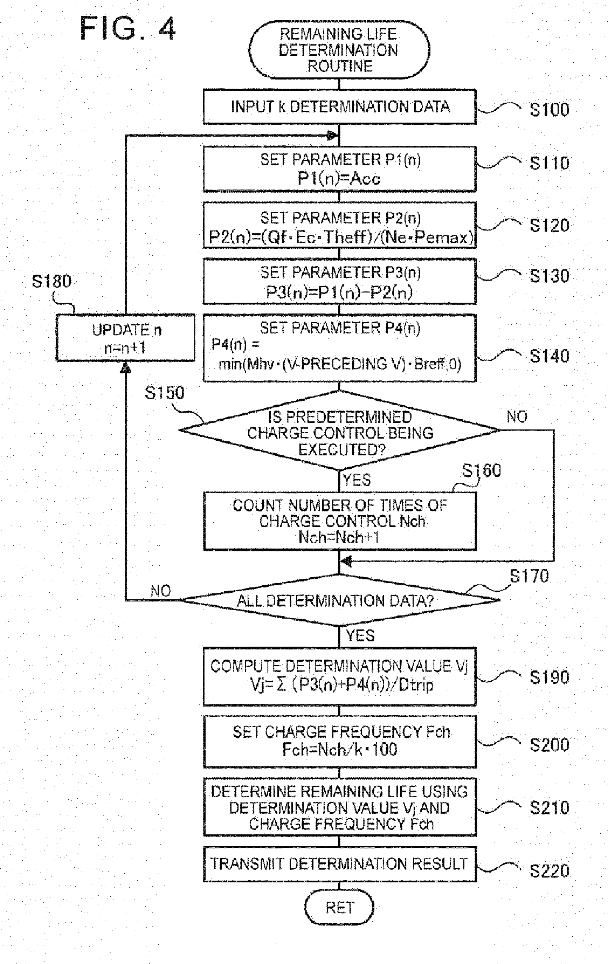

When a non-time-series data set including the vehicle identification number VIN of the hybrid automobile 20 as the target for determination of the remaining life (degradation) of the battery 50 is received, the computer 92 of the management center 90 determines the remaining life (degradation) of the battery 50 using the time-series data sets for one trip corresponding to the vehicle identification number VIN saved in the storage device 94 and the non-time-series data set. FIG. 4 is a flowchart illustrating an example of a remaining life determination routine executed by the computer 92. The routine is executed when a non-time-series data set is received.

When the routine is executed, the computer 92 of the management center 90 executes a process of receiving input of k determination data, including the vehicle identification number VIN as the target for determination of the remaining life (degradation) of the battery 50, from the storage device 94 in the order of the detection time Time from the older side (step S100).

Subsequently, a parameter (first parameter) P1(n) is set to the accelerator operation amount Acc included in the determination data with the n-th oldest detection time Time, among the k determination data (step S110). n is a natural number with a value of 1 or more and k or less. The initial value of n is set to a value of 1. That is, when step S110 is first executed, the parameter P1(1) is set to the accelerator operation amount Acc included in the oldest determination data, among the k determination data. In the HV travel mode, as discussed above, the hybrid automobile 20 is controlled so as to travel using the required power Pd* which is set using the required torque Td* which is based on the accelerator operation amount Acc. Thus, the parameter P1(n) reflects required power required for travel at the corresponding detection time Time.

Next, a parameter (second parameter) P2(n) is computed based on the fuel injection amount Qf included in the n-th oldest determination data, the rotational speed Ne of the engine 22, and the following formula (1) (step S120). In the formula (1), "Ec" is the amount of heat (energy) generated when a unit mass of fuel is combusted. "Theff" is the thermal efficiency of the engine 22. "Pemax" is the maximum output determined in advance through experiments, analyses, etc. as the maximum value of power that can be output from the engine 22. From the formula (1), the parameter P2(n) reflects power output from the engine 22 at the corresponding detection time Time.

$$P2(n) = (Qf \cdot Ec \cdot Theff)/(Ne \cdot Pemax) \cdots (1)$$

Then, a parameter (third parameter) P3(n) is set to a value obtained by subtracting the parameter P2(n) from the parameter P1(n) (step S130). The parameter P1(n) reflects required power required for travel at the corresponding detection time Time. The parameter P2(n) reflects power output from the engine 22 at the corresponding detection time Time. Thus, the parameter P3(n), which is obtained by subtracting the parameter P2(n) from the parameter P1(n), reflects electric power input to and output from the motor MG2, that is, electric power input to and output from the battery 50, at the corresponding detection time Time.

Subsequently, a parameter P4(n) is set to the smaller one of a value of 0 and a value (= Mhv · (V - preceding V) · Breff) obtained by multiplying the vehicle weight Mhv, which is included in the non-time-series data set, by a deceleration amount (= V - preceding V), which is obtained by subtracting the vehicle speed V (preceding V) included in the determination data input in the (n-1)-th order from the vehicle speed V included in the determination data input in the n-th order, and a regeneration efficiency Breff of the motor MG2 (step S140). When step S140 is first executed, the initial value of the preceding V is set to a value of 0. The value (= Mhv · (V - preceding V) · Breff) indicates electric power regenerated by the motor MG2 to be stored in the battery 50 during deceleration. From the formula (2), the parameter P4(n) is set to a value of 0 during acceleration, and to electric power regenerated by the motor MG2 to be stored in the battery 50 during deceleration. Thus, the parameter P4(n) reflects electric power input to the battery 50 at the corresponding detection time Time.

$$P4(n) = min(Mhv \cdot (V - preceding\ V) \cdot Breff, 0) \cdots (2)$$

Subsequently, it is determined whether the predetermined charge control discussed above is being executed based on the vehicle speed V, the accelerator operation amount Acc, and the fuel injection amount Qf which are included in the determination data with the n-th oldest detection time Time, among the k determination data (step S150). Here, it is determined that the predetermined charge control discussed above is being executed when the vehicle speed V is equal to or less than a predetermined vehicle speed Vref (e.g. 65 km/hour, 70 km/hour, 75 km/hour, etc.), the accelerator operation amount Acc is 0%, and the fuel injection amount Qf is not a value of 0.

When it is determined in step S150 that the predetermined charge control discussed above is being executed, a number of times of charge control Nch is incremented by a value of 1 (step S160), and the process proceeds to step S170. When step S160 is first executed, the number of times of charge control Nch is set to a value of 1. When it is determined in step S150 that the predetermined charge control discussed above is not being executed, step S160 is not executed, and the process proceeds to step S170.

Subsequently, it is determined whether the parameters P3(n), P4(n) have been set for all the input determination data, that is, parameters P3(1) to P3(k), P4(1) to P4(k) have been set as time-series data in one trip (step S170). When the parameters P3(1) to P3(k), P4(1) to P4(k) have not been set, n is incremented by a value of 1 (n is increased by 1 to be updated) (step S180), and the process returns to step S110 to execute step S110 and the subsequent steps. In this manner, steps S110 to S180 are repeatedly performed until the parameters P3(n), P4(n) have been set for all the input determination data. Thus, the number of times of charge control Nch indicates the number of times that it is determined based on the determination data that the predetermined charge control discussed above is being executed, and corresponds to the time for which the predetermined charge control is executed in the trip in the hybrid automobile 20.

When the parameters P3(1) to P3(k), P4(1) to P4(k) have been set in step S170, a determination value Vj is set to a value obtained by dividing an integrated value of the sum of the parameter P3(n) and the parameter P4(n) in the trip by the travel distance Dtrip using the parameters P3(1) to P3(k), P4(1) to P4(k) and the following formula (3) (step S190). As discussed above, the parameters P3(n), P4(n) reflect electric power output from the battery 50 (a positive value), and electric power input to the battery 50 during deceleration (a value of 0 or less), at the corresponding detection time Time. Thus, the determination value Vj reflects the integrated value of electric power input to and output from the battery 50 per unit travel distance in the trip.

$$Vj = \Sigma(P3(n) + P4(n))/Dtrip \cdots (3)$$

Subsequently, a charge frequency Fch is set to a value obtained by dividing the number of times of charge control Nch by a number k of the determination data and multiplying the resulting value by a value of 100 (step S200). Data such as the vehicle speed V that constitute one piece of the determination data are data transmitted from the hybrid automobile 20 each predetermined time. Thus, the number k of the determination data corresponds to the required time for the trip of the hybrid automobile 20. Thus, the charge frequency Fch corresponds to the proportion of the time for which the predetermined charge control is executed in the trip to the required time for the trip.

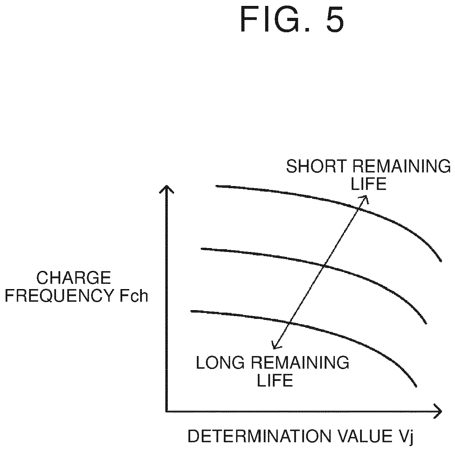

When the determination value Vj and the charge frequency Fch are set in this manner, the remaining life of the battery 50 is determined using the determination value Vj, the charge frequency Fch, and a remaining life setting map stored in advance in the ROM (not illustrated) (step S210). FIG. 5 illustrates an example of the remaining life setting map. In FIG. 5, the remaining life of the battery 50 is set such that the remaining life is shorter when the determination value Vj is larger than when the determination value Vj is smaller, and such that the remaining life is shorter when the charge frequency Fch is higher than when the charge frequency Fch is lower. This is based on the fact that the remaining life of the battery 50 is strongly correlated with an integrated value of electric power input to and output from the battery 50 and the charge frequency Fch, that degradation of the battery 50 progresses faster to make the remaining life thereof shorter when the integrated value of electric power input to and output from the battery 50 is larger than when the integrated value is smaller, and that the battery 50 has already been degraded and the power accumulation proportion SOC has been lowered when the charge frequency Fch is high. The parameters P3(1) to P3(k), P4(1) to P4(k) are set using the rotational speed Ne of the engine 22, the fuel injection amount Qf, the accelerator operation amount Acc, and the vehicle speed V. Meanwhile, the number of times of charge control Nch is considered to be set based on the vehicle speed V, the accelerator operation amount Acc, and the fuel injection amount Qf, since the number of times of charge control Nch is incremented by a value of 1 when it is determined based on the vehicle speed V, the accelerator operation amount Acc, and the fuel injection amount Qf that charge control is being executed. That is, the charge frequency Fch is set based on the vehicle speed V, the accelerator operation amount Acc, and the fuel injection amount Qf. As discussed above, the rotational speed Ne of the engine 22, the fuel injection amount Qf, the accelerator operation amount Acc, and the vehicle speed V are each a user operation amount or a control amount to be used for control (travel control) of the engine 22 and the motors MG1, MG2 in the HV travel mode and the EV travel mode. Thus, degradation of the battery 50 can be determined precisely using the user operation amounts and the control amounts which are used to control the hybrid automobile 20 without adding a special device for determining the remaining life of the battery 50.

The remaining life (degradation) of the battery 50 can be determined using a determination data set and the parameters P3(1) to P3(k), P4(1) to P4(k) for one trip. Thus, the storage capacity of the storage device 94 can be reduced compared to a configuration in which all the determination data sets and the parameters P3, P4 are stored for a period since the system of the hybrid automobile 20 is first started after completion of manufacturing to the present. Thus, degradation of the secondary battery can be determined even if no mass storage device is provided.

The inventors have found that if the battery 50 is constituted as a nickel-metal-hydride secondary battery, it is difficult to predict progress of degradation of the battery 50 based on an internal resistance value of the nickel-metal-hydride secondary battery, since the internal resistance value increases abruptly with degradation of the battery 50 progressing abruptly when the time of use exceeds a certain time. In the embodiment, degradation of the battery 50 is determined using the user operation amounts and the control amounts which are used for travel control of the hybrid automobile 20. Thus, degradation can be determined precisely even if the battery 50 is constituted as a nickel-metal-hydride secondary battery.

When the remaining life (degradation) of the battery 50 is determined in this manner, the determination result and the corresponding vehicle identification number VIN are transmitted to the communication device 96 (step S220).

When the determination result and the vehicle identification number VIN are received, the communication device 96 transmits the determination result to the hybrid automobile 20 corresponding to the received vehicle identification number VIN. When the determination result is received, the hybrid automobile 20 indicates the determination result on a display (not illustrated) in the vehicle. Consequently, the user can be informed of determination result of the battery 50, and the user can be prompted to replace the battery 50 when the remaining life of the battery 50 is short.

With the vehicle diagnosis system 10 including the degradation determination device for a secondary battery according to the embodiment described above, degradation of the secondary battery can be determined based on control executed in the hybrid vehicle, by determining whether the predetermined charge control is executed based on the vehicle speed V, the accelerator operation amount Acc, and the fuel injection amount Qf, and determining that degradation of the battery 50 has progressed when the charge frequency Fch, which is a value obtained by dividing the number of times of charge control Nch by the number k of the determination data and multiplying the resulting value by a value of 100, is higher than when the charge frequency Fch is lower.

In addition, degradation of the battery can be determined more adequately by determining that the degradation progresses faster when a value obtained by dividing an integrated value of time-series data on the parameter P3(n) in the trip by the travel distance Dtrip in the trip is larger than when the value is smaller, the parameter P3(n) being the difference between the parameter P1(n) which is based on the accelerator operation amount Acc and the parameter P2(n) which is based on the fuel injection amount Qf.

In the vehicle diagnosis system 10 including the degradation determination device for a secondary battery according to the embodiment, it is determined whether the predetermined charge control is executed based on the vehicle speed V, the accelerator operation amount Acc, and the fuel injection amount Qf in step S150 of the remaining life determination routine in FIG. 4. However, the rotational speed Ne of the engine 22 may be used in place of the fuel injection amount Qf. In this case, it may be determined that the predetermined charge control is executed when the vehicle speed V is equal to or less than the predetermined vehicle speed Vref, the accelerator operation amount Acc is 0%, and the rotational speed Ne of the engine 22 is higher than an idle rotational speed Nidl.

In the vehicle diagnosis system 10 including the degradation determination device for a secondary battery according to the embodiment, a charge frequency Fch is set to a value obtained by dividing the number of times of charge control Nch by the number k of the determination data and multiplying the resulting value by a value of 100 in step S200 of the remaining life determination routine in FIG. 4. However, the charge frequency Fch may be set to a value obtained by dividing the number of times of charge control Nch by the number k of the determination data, or may be set to a value (ratio of the time for which the predetermined charge control is executed to the required time for the trip) obtained by measuring the time for which the predetermined charge control is executed in the trip and the required time for the trip and dividing the time for which the predetermined charge control is executed in the trip by the required time for the trip.

In the vehicle diagnosis system 10 including the degradation determination device for a secondary battery according to the embodiment, the parameter P1(n) is set to the accelerator operation amount Acc in step S110 of the remaining life determination routine in FIG. 4. However, the parameter P1(n) may be set to the required power Pd* which is obtained by multiplying the required torque Td*, which is based on the accelerator operation amount Acc and the vehicle speed V, by the rotational speed Nd of the drive shaft 36.

In the vehicle diagnosis system 10 including the degradation determination device for a secondary battery according to the embodiment, the parameters P3(1) to P3(k), P4(1) to P4(k) are set in steps S130, S140, respectively, of the remaining life determination routine in FIG. 4, and the determination value Vj is set using the set parameters P3(1) to P3(k), P4(1) to P4(k) in step S190. However, step S140 may not be executed, and the determination value Vj may be set using only the parameters P3(1) to P3(k). In this case, the following formula (5) may be used in place of the formula (3) discussed above in step S190.

$$Vj = \Sigma P3(n)/Dtrip \cdots (5)$$

In the vehicle diagnosis system 10 including the degradation determination device for a secondary battery according to the embodiment, the remaining life (degradation) of the battery 50 is determined based on the parameters P3(1) to P3(k), P4(1) to P4(k) that are time-series data on the parameters P3(n), P4(n) for one trip. However, the period for which time-series data on the parameters P3(n), P4(n) are collected is not limited to one trip, and may be two trips or more, and may be determined as appropriate. For example, when each hybrid automobile 20 is in service as a taxi, the remaining life (degradation) of the battery 50 may be determined based on time-series data on the parameters P3(n), P4(n) for the number of hours for which the taxi is in service in one day.

In the vehicle diagnosis system 10 including the degradation determination device for a secondary battery according to the embodiment, the determination value Vj is computed by executing steps S110 to S140 and S190, and the remaining life is determined using the determination value Vj and the charge frequency Fch in step S210. However, steps S110 to S140 and S190 may not be executed, and the remaining life may be determined using only the charge frequency Fch in step S210. In this case, degradation has progressed when the charge frequency Fch is high compared to when the charge frequency Fch is low. Thus, it may be determined that the remaining life is shorter when the charge frequency Fch is higher than when the charge frequency Fch is lower.

In the vehicle diagnosis system 10 including the degradation determination device for a secondary battery according to the embodiment, the computer 92 of the management center 90 executes the remaining life determination routine in FIG. 4. However, some or all of the processes of the remaining life determination routine in FIG. 4 may be executed by the HV ECU 70 of the hybrid automobile 20.

In the vehicle diagnosis system 10 including the degradation determination device for a secondary battery according to the embodiment, the battery 50 is constituted as a nickel-metal-hydride secondary battery. However, the battery 50 may be a secondary battery, and may be a lithium-ion battery, for example.

In the embodiment, the degradation determination device for a secondary battery according to the present invention is mounted on the management center 90. However, the degradation determination device for a secondary battery according to the present invention may be mounted on the hybrid automobile 20.

In the embodiment, the degradation determination device for a secondary battery according to the present invention is applied to the hybrid automobile 20 which includes the engine 22, the motors MG1, MG2, and the planetary gear 30. However, the thus configured hybrid automobile 20 is not limiting, and the degradation determination device for a secondary battery according to the present invention may be applied to a hybrid automobile 20 with a different configuration, as long as the hybrid automobile includes an engine that outputs power for travel, a motor that outputs power for travel, and a secondary battery that exchanges electric power with the motor. The degradation determination device for a secondary battery according to the present invention may also be applied to vehicles other than automobiles, such as trains and construction machines.

The correspondence between the main elements of the embodiment and the main elements of the invention described in the "SUMMARY OF THE INVENTION" field will be described. In the embodiment, the engine 22 is an example of the "engine", the motor MG2 is an example of the "motor", the battery 50 is an example of the "secondary battery", the engine ECU 24, the motor ECU 40, and the HV ECU 70 are examples of the "control device", the hybrid automobile 20 is an example of the "hybrid vehicle", and the computer 92 of the management center 90 is an example of the "degradation determination device for a secondary battery".

The correspondence between the main elements of the embodiment and the main elements of the invention described in the "SUMMARY OF THE INVENTION" field does not limit the elements of the invention described in the "SUMMARY OF THE INVENTION" field, since the embodiment is an example for specifically describing a mode for carrying out the invention described in the "SUMMARY OF THE INVENTION" field. That is, the invention described in the "SUMMARY OF THE INVENTION" field should be construed based on the description in the field, and the embodiment is merely a specific example of the invention described in the "SUMMARY OF THE INVENTION" field.

While a mode for carrying out the present invention has been described above using an embodiment, the present invention is not limited to the embodiment in any way. It is a matter of course that the present invention may be implemented in a variety of modes without departing from the scope and spirit of the present invention.

The present invention is applicable to the industry of manufacturing degradation determination devices for a secondary battery etc.

**Claims**

1. A degradation determination device for a secondary battery (50), the degradation determination device being used for a hybrid vehicle (20) and configured to determine degradation of the secondary battery, the hybrid vehicle including an engine (22) configured to output power for travel, a motor (MG1,MG2) configured to output power for travel, the secondary battery (50) configured to exchange electric power with the motor, and a control device (70) configured to execute predetermined charge control for controlling the engine (22) and the motor (MG1,MG2) using at least a vehicle speed (V), an accelerator operation amount (Acc), and a fuel injection amount (Qf) of the engine or a rotational speed (Ne) of the engine (22) such that the secondary battery is charged using power from the engine (22) when a predetermined condition is established, the degradation determination device comprising a processor (92) configured to:

   determine whether the predetermined charge control is executed based on the vehicle speed (V), the accelerator operation amount (Acc), and the fuel injection amount (Qf) or the rotational speed (Ne); and
   determine that degradation of the secondary battery has progressed when a charge frequency (Fch) is high compared to when the charge frequency is low, the charge frequency (Fch) being a ratio of a time for which the predetermined charge control is executed to a required time for a predetermined period.

**2.** The degradation determination device according to claim 1, wherein the predetermined period is a period since a system of the hybrid vehicle is started until the system is stopped.

**3.** The degradation determination device according to claim 1 or 2, wherein the processor (92) is configured to determine that the degradation progresses faster when a value obtained by dividing an integrated value of time-series data on a third parameter (P3(n)) in the predetermined period by a travel distance (Dtrip) in the predetermined period is larger than when the value is smaller, the third parameter being a difference between a first parameter (P1(n)) based on the accelerator operation amount (Acc) and a second parameter (P2(n)) based on the fuel injection amount (Qf).

**4.** The degradation determination device according to claim 1 or 2, wherein the processor (92) is configured to determine that the degradation progresses faster when a value obtained by calculating a sum of an integrated value of time-series data on a third parameter (P3(n)) in the predetermined period and an integrated value of time-series data on a fourth parameter (P4(n)) in the predetermined period and dividing the calculated sum by a travel distance (Dtrip) in the predetermined period is larger than when the value is smaller, the third parameter (P3(n)) being a difference between a first parameter (P1(n)) based on the accelerator operation amount (Acc) and a second parameter (P2(n)) based on the fuel injection amount (Qf), and the fourth parameter (P4(n)) being based on a deceleration amount of the hybrid vehicle (20).

# FIG. 1

20

20

20

10

90

MANAGEMENT CENTER

COMPUTER — 92

STORAGE DEVICE — 94

COMMUNICATION DEVICE — 96

# FIG. 2

# FIG. 3

FIG. 4

$$\text{REMAINING LIFE} \atop \text{DETERMINATION} \atop \text{ROUTINE}$$

INPUT k DETERMINATION DATA — S100

SET PARAMETER P1(n)
$P1(n)=Acc$ — S110

SET PARAMETER P2(n)
$P2(n)=(Qf \cdot Ec \cdot Theff)/(Ne \cdot Pemax)$ — S120

SET PARAMETER P3(n)
$P3(n)=P1(n)-P2(n)$ — S130

S180

UPDATE n
$n=n+1$

SET PARAMETER P4(n)
$P4(n) = \min(Mhv \cdot (V\text{-PRECEDING } V) \cdot Breff, 0)$ — S140

S150

IS PREDETERMINED CHARGE CONTROL BEING EXECUTED? — NO

YES — S160

COUNT NUMBER OF TIMES OF CHARGE CONTROL Nch
$Nch=Nch+1$

NO — ALL DETERMINATION DATA? — S170

YES

COMPUTE DETERMINATION VALUE Vj
$Vj=\sum (P3(n)+P4(n))/Dtrip$ — S190

SET CHARGE FREQUENCY Fch
$Fch=Nch/k \cdot 100$ — S200

DETERMINE REMAINING LIFE USING DETERMINATION VALUE Vj AND CHARGE FREQUENCY Fch — S210

TRANSMIT DETERMINATION RESULT — S220

RET

# FIG. 5

SHORT REMAINING
LIFE

CHARGE
FREQUENCY Fch

LONG REMAINING
LIFE

DETERMINATION VALUE Vj

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/332017 A1 (HISANO TAISHI [JP]) 12 December 2013 (2013-12-12) * abstract * * paragraph [0013] – paragraph [0014] * * paragraph [0031] – paragraph [0032] * * paragraph [0035] – paragraph [0039] * * paragraph [0052] – paragraph [0053] * * figures 1,7,8,11 * | 1,2 | INV. B60L50/16 B60L50/61 B60L58/12 B60L58/16 B60L3/00 G01R31/392 H02J7/00 B60K6/445 B60W20/00 |
| X | US 2007/285097 A1 (ZETTEL ANDREW M [US] ET AL) 13 December 2007 (2007-12-13) * paragraph [0014] – paragraph [0018] * * paragraph [0031] – paragraph [0032] * * paragraph [0039] – paragraph [0040] * * figures 1,4 * | 1,3,4 | |
| X | JP 2009 107554 A (TOYOTA MOTOR CORP) 21 May 2009 (2009-05-21) * abstract * * paragraph [0023] – paragraph [0028] * * paragraph [0030] – paragraph [0031] * * paragraph [0036] – paragraph [0037] * * figures 1,8-11 * | 1,2 | |
| X | US 2007/284163 A1 (HEAP ANTHONY H [US] ET AL) 13 December 2007 (2007-12-13) * abstract * * paragraph [0007] – paragraph [0008] * * paragraph [0018] – paragraph [0020] * * paragraph [0055] – paragraph [0057] * * figures 1,5 * | 1,3,4 | |

TECHNICAL FIELDS
SEARCHED (IPC)

B60W
B60L
B60K
H02J
G01R

The present search report has been drawn up for all claims

| Place of search | Date of completion of the search | Examiner |
|---|---|---|
| The Hague | 24 March 2022 | Molnar, Sabinus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...............................................................................
& : member of the same patent family, corresponding
document

EPO FORM 1503 03.82 (P04C01)

EP 3 992 013 A1

## ANNEX TO THE EUROPEAN SEARCH REPORT
## ON EUROPEAN PATENT APPLICATION NO.

EP 21 19 7567

This annex lists the patent family members relating to the patent documents cited in the above-mentioned European search report.
The members are as contained in the European Patent Office EDP file on
The European Patent Office is in no way liable for these particulars which are merely given for the purpose of information.

24-03-2022

| Patent document cited in search report | | Publication date | Patent family member(s) | | Publication date |
|---|---|---|---|---|---|
| US 2013332017 | A1 | 12-12-2013 | CN | 103481763 A | 01-01-2014 |
| | | | JP | 5742788 B2 | 01-07-2015 |
| | | | JP | 2013256173 A | 26-12-2013 |
| | | | US | 2013332017 A1 | 12-12-2013 |
| US 2007285097 | A1 | 13-12-2007 | CN | 101086518 A | 12-12-2007 |
| | | | DE | 102007026134 A1 | 21-02-2008 |
| | | | US | 2007285097 A1 | 13-12-2007 |
| JP 2009107554 | A | 21-05-2009 | NONE | | |
| US 2007284163 | A1 | 13-12-2007 | CN | 101085605 A | 12-12-2007 |
| | | | DE | 102007026136 A1 | 27-12-2007 |
| | | | US | 2007284163 A1 | 13-12-2007 |

For more details about this annex : see Official Journal of the European Patent Office, No. 12/82

**EP 3 992 013 A1**

**REFERENCES CITED IN THE DESCRIPTION**

**Patent documents cited in the description**

- JP 2008076295 A